# EUROPÄISCHE PATENTANMELDUNG

(11) **EP 0 571 885 A1**
(43) Veröffentlichungstag der Anmeldung: **01.12.1993**
(21) Anmeldenummer: 93108110.3
(22) Anmeldetag: 18.05.1993
(51) Int. Cl.: C04B 35/00, H01L 39/24

(54) **Giessmasse zur Herstellung keramischer Grünfolien aus Precursormaterial für Hochtemperatursupraleiter und ihre Verarbeitung**

(30) Priorität: 28.05.1992 DE 4217638
(71) Anmelder: HOECHST AKTIENGESELLSCHAFT, D-65926 Frankfurt am Main (DE)
(72) Erfinder: Lang, Christoph, Dr., W-6230 Frankfurt/M. 80 (DE); Hessel, Friedrich, Dr., W-6500 Mainz (DE); Budesheim, Carsten, W-6230 Frankfurt/M. 80 (DE); Hettich, Bernhard, Dr., W-6239 Eppstein/Ts. (DE)

(57) **Zusammenfassung**

Es wird eine Gießmasse für keramische Grünfolien aus hochtemperatursupraleitendem Precursormaterial beschrieben. Die Gießmasse enthält als keramisches Ausgangsmaterial für den Foliengießprozeß ein Precursorpulver aus den Elementen Bi, Sr, Ca, Cu und O, das durch modifizierte Copräzipitation hergestellt wird. Das Pulver besitzt eine mittlere Korngröße von < 5 µm und es weist eine spezifische Oberfläche von > 25 m²/g auf. Es wird auch ein Verfahren zur Herstellung der Gießmasse beschrieben, ein Verfahren zum Herstellen eines gegossenen Bauteils sowie ein Verfahren zum Herstellen eines hochtemperatursupraleitenden Bauteils.

## Beschreibung

Die vorliegende Erfindung betrifft eine Gießmasse für keramische Grünfolien aus hochtemperatursupraleitendem (HTSL) Precursormaterial und deren Umsetzung zu supraleitendem Material.

Es zeichnet sich ab, daß die sogenannten Hochtemperatursupraleiter, bei denen Übergangstemperaturen in den supraleitenden Zustand von größer 77 K gemessen werden, prinzipiell in zwei technisch relevante Verbindungsklassen einzuordnen sind. Bei den Y/Ba/Cu/O-Supraleitern ist dies YBa₂Cu₃O₇₋ₓ mit einer Sprungtemperatur von 92 K, während sich bei den Bi(Pb)/Sr/Ca/Cu/O-Supraleitern das allgemeine Interesse auf Bi₂Sr₂CaCu₂O₈₊ₓ (T_{c}=92 K) und Bi₂Sr₂Ca₂Cu₃O₁₀₊ₓ (T_{c}=110 K) konzentriert. Bei den beiden letztgenannten Verbindungen ist es gelungen, unter bestimmten Bedingungen die schwache Verbindung der oxidkeramischen Körner aufzuheben. So erlaubt die Pulver-im-Rohr-Technologie nach aufwendigen Verformungs-, und Glühschritten die Herstellung von Silberbandleitern mit hohen kritischen Stromdichten (vgl. M. Ueyama et al., Jpn. Jrnl. Appl. Phys. Vol. 30 (1991), S. 1384 - 1386). Der Einsatz von HTSL-Silberbandleitern ist in der Elektrotechnik am vielversprechendsten, wobei insbesondere der Bau von Magneten, Transformatoren oder Motoren angestrebt ist.

Eine weitere Möglichkeit zur Formgebung bei der Verbindung Bi₂Sr₂CaCu₂O₈₊ₓ ergibt sich durch die Eigenschaft des kongruenten Aufschmelzens. Die Formgebung über ein Schmelzverfahren (vgl. J. Bock et al., EP 0 362 492 A2) ist jedoch zur Zeit allenfalls auf Anwendungen in der Elektrotechnik begrenzt, da es sehr schwierig ist, gleichermaßen kleine wie komplizierte Geometrien zu realisieren.

Eine vielfältigere Formgebung erlaubt das vor allen Dingen aus der herkömmlichen Oxidkeramikverarbeitung bekannte Foliengießen. Dieses sogenannte 'tape casting' ist die Auftragung einer Dispersion keramischer Materialien in einer flüssigen Phase auf ein in der Regel kontinuierlich laufendes Band. Keramische Materialien sind dabei Zirkondioxid, Aluminiumoxid, Aluminiumnitrid, Siliziumcarbid oder wie im vorliegenden Fall Hochtemperatursupraleiter. Die flüssige Phase ist ein Lösemittel bzw. ein Lösemittelgemisch, welches zusätzlich noch Dispergierhilfsmittel, Binder und Weichmacher enthalten kann. Außerdem ist es möglich, den Schlicker außer auf ein Band alternativ in Formen zu gießen. So ausgeschnittene, ausgestanzte oder vorgeformte Formteile werden dann einer Temperbehandlung unterzogen, bei der zunächst die organischen Bestandteile ausgetrieben werden und dann das fertige Bauteil nach einem materialspezifischen Umsetzungs- oder Sinterschritt entsteht.

Das Foliengießen, sowie typische organische Hilfsstoffe sind beschrieben in Keram. Zeitschr. 38 Nr. 2 (1986), S. 79 - 82. Die Anwendung dieses Prinzips auf Hochtemperatursupraleiter für die Zusammensetzung Bi₂Sr₂CaCu₂O₈₊ₓ wird u.a. beschrieben von J. Shiomoyama et al. in Jpn. J. Appl. Phys. Vol. 31 (1992), S. 163 - 165. Allerdings wird nach dem bekannten Verfahren fertiges Pulver mit hochtemperatursupraleitenden Eigenschaften zusammen mit Trichlorethylen als Lösungsmittel verarbeitet, was im Betrieb oft zu störenden Gefahrenquellen führt.

Der vorliegenden Erfindung lag daher die Aufgabe zugrunde, für Hochtemperatursupraleiterpulver anderer Qualitäten ein Verfahren zu entwickeln, das die Formgebung über einen Schlicker möglichst mit halogenfreien Lösungsmitteln erlaubt.

Gelöst wird diese Aufgabe durch eine Gießmasse der eingangs genannten Gattung, deren Kennzeichenmerkmal darin zu sehen ist, daß sie als keramisches Ausgangsmaterial für den Foliengießprozeß ein Precursorpulver aus den Elementen Bi, Sr, Ca, Cu und O enthält, das durch modifizierte Copräzipitation hergestellt wird, eine mittlere Korngröße d₅₀ von < 5 µm besitzt und eine spezifische Oberfläche von > 25 m²/g.

Erfindungsgemäß entspricht die Zusammensetzung des Precursorpulvers den supraleitenden Phasen Bi₂Sr₂CaCu₂O₈₊ₓ, Bi₄Sr₄Ca₁Cu₃O₁₄₊ₓ oder Bi₂Sr₂Ca₂Cu₃O₁₀₊ₓ, beziehungsweise Ansätzen, die zu weitgehend phasenreinen Proben führen, entspricht, wobei Bi partiell durch Pb ersetzt sein kann.

Das Verfahren der modifizierten Copräzipitation ist bekannt und beispielsweise in der DE-A-41 22 893 beschrieben. Die mittlere Korngröße von < 5 µm wird erreicht, indem das Copräzipitat möglichst feinverteilt gefällt wird. Im allgemeinen genügt eine Zugabe mittels Tropftrichter, vorteilhafter ist aber die Zugabemethode per Ultraschallvernebelung. Um das Zusammensintern der reaktiven Spezies zu verhindern, sollte die Aufheizgeschwindigkeit 3 K/min nicht überschreiten und die Kalzinierungstemperatur soll maximal 750 °C erreichen. Das erfindungsgemäß hergestellte Precursorpulver besitzt überraschend eine sehr hohe Reaktivität und läßt sich über einen Sinterschritt oder ein partielles Aufschmelzen schnell zum gewünschten hochtemperatursupraleitenden Produkt umsetzen.

Die hohe spezifische Oberfläche des erfindungsgemäßen Precursormaterials mit bis zu ca. 30 m²/g bedingt jedoch andere organische Hilfsmittel der Mischung gegenüber dem herkömmlichen Verfahren. Ein erfindungsgemäß bevorzugtes Lösungsmittel für die keramische Matrix ist ein Gemisch aus Toluol (20 - 40 Gew.-%) und Ethanol (entsprechend 60 - 80 Gew.-%), insbesondere die Mischung Toluol/Ethanol 32/68 führt in der Praxis zu guten Ergebnissen.

Geeignete Dispergiermittel sind vorzugsweise tertiäre Amine. Die besten Ergebnisse in Kombination mit Toluol/Ethanol erzielt man mit langkettigen tertiären Aminen mit 10 bis 21 C-Atomen. Insbesondere ®Genamin CO 20, (Fa. Hoechst) CH₃(CH₂)₁₂N((CH₂CH₂O)ₓH)₂ (x = variabel im Bereich von 2 bis 6) dispergiert die Supraleiterkeramik zufriedenstellend.

Binder sind im allgemeinen langkettige Verbindungen mit wenigstens 17 C-Atomen, die den Kontakt der Matrix innerhalb der Grünfolie intensivieren. Die Verbindung mit der größten Wirkung ist ®Acryloid, Fa. Rhom und Haas, (CH₂COOC₂H₅COOCH₂)ₙ (n = variabel im Bereich von 2 bis 8) mit 0,6 Gew.-% H₃O⁺-Ionen. Eine weitere Verbesserung der Eigenschaften der Grünfolie auf einer Gießunterlage aus Silber wird durch die Verwendung eines Weichmachers erreicht. Vorzugsweise beeinflußt er nach den Untersuchungen die Homogenität der Folie. Von den verfügbaren Substanzen ist ®Palatinol C (Fa. BASF), ein Phthalsäurealkylester der Zusammensetzung C₆H₄(COO(CH₂)₃CH₃)₂, hervorzuheben.

Wichtig ist jedoch nicht nur die Art der organischen Zusätze, sondern auch die prozentuale Zusammensetzung der Formulierung. Sie beeinflußt die Eigenschaften des Schlickers und der daraus hergestellten Grünfolie ganz entscheidend.

Die erfindungsgemäß bevorzugte prozentuale Zusammensetzung des Schlickers vor der Verarbeitung ist in der nachfolgenden Tabelle I angegeben:

**Tabelle I**

| | Gew.-% | optimiert |
|---|---|---|
| keram. Matrix | 50 - 60 | 56 |
| Lösungsmittel | 30 - 45 | 38 |
| Dispergiermittel | 0.2 - 4 | 1 |
| Binder | 1 - 6 | 3 |
| Weichmacher | 0.2 - 5 | 2 |

Die Formulierung des Schlickers wird in diesen Grenzen durch die Zusammensetzung des nach der Copräzipitation anfallenden Oxalatpulvers bestimmt. Der in der Tabelle I angegebene optimierte Wert gilt z.B. für ein copräzipitiertes Oxalatpulver der Zusammensetzung Bi_{1.8}Pb_{0.4}Sr₂Ca_{2.2}Cu₃Oₓ, das 10 Stunden unter Luft bei 400°C zersetzt und anschließend 20 Stunden unter O₂-Atmosphäre gesintert wurde.

Zur Herstellung des Schlickers wird nun das zum Precursor zersetzte Oxalatpulver in das Lösungsmittelgemisch eingegeben und mit dem Dispergiermittel im Taumler oder auf dem Rollbock einige Stunden homogenisiert. Nach einer kurzen Ultraschallbehandlung folgt die Zugabe des Binders sowie des Weichmachers. Nach einem weiteren Homogenisierungsschritt (Taumler oder Rollbock) wird der Schlicker im Vakuum entgast und dann verarbeitet. Die Viskosität des Schlickers beträgt ca. 300 MPas, kann aber auch im weiteren Bereich von 100 bis 600 MPas liegen.

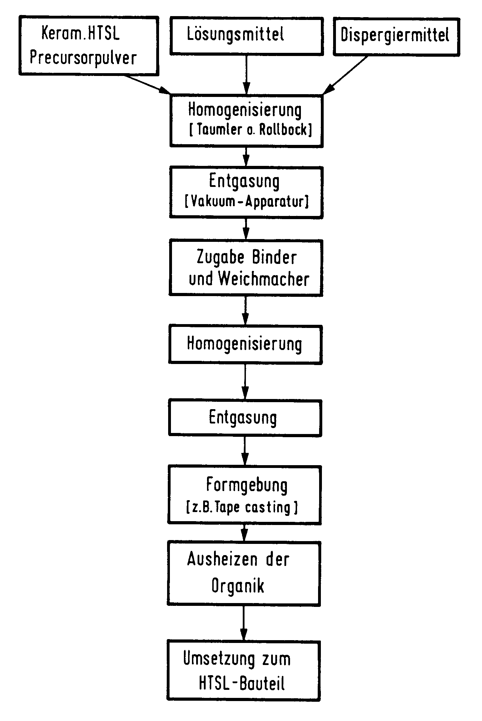

Beim Foliengießprozeß wird zum Erreichen reproduzierbarer Ergebnisse mit einem Gießschuh in einer Halteapparatur auf ein Endlosband mit automatischem Vortrieb vergossen. Im nächsten Schritt verdampft das Lösungsmittel möglichst kontrolliert bei Temperaturen im Bereich von 60 bis 120 °C, dann werden die verbleibenden organischen Anteile zwischen 200 und 500 °C ausgeheizt. Die Umsetzung zur gewünschten supraleitenden Phase, z.B. Bi₂Sr₂CaCu₂O₈₊ₓ oder Bi₂Sr₂Ca₂Cu₃O₁₀₊ₓ erfolgt dann in Filmform oder in der gegossenen Form nach den aus der Literatur bekannten Herstellbedingungen für die entsprechenden Verbindungen. Das Ergebnis ist ein weitgehend phasenreines Bauteil mit vergleichbaren supraleitenden Eigenschaften zum herkömmlich auf dem festkörperchemischen Wege präparierten Material. Abb. 1 zeigt den schematischen Prozeßablauf.

Anhand der nachfolgenden Ausführungsbeispiele soll die Erfindung noch deutlicher beschrieben werden, ohne aber auf die konkret dargestellten Ausführungsformen beschränkt zu sein.

### Beispiel 1

Ein über Oxalatfällung hergestelltes Pulver der Zusammensetzung Bi_{1.8}Pb_{0.4}Sr₂Ca_{2.2}Cu₃Oₓ wird zu einer Gießmasse mit dem Lösungsmittelgemisch Toluol/Ethanol 32/68 verarbeitet. Das Pulver wurde aus einem Copräzipitat über eine Zeit von 10 h bei einer Temperatur von 450°C vorkalziniert und weist einen d₅₀-Wert von 1,6 µm, sowie eine spezifische Oberfläche von 30 m²/g auf. Die Zusammensetzung des Schlickers entspricht 54 Gew.-% Precursorpulver, 40 Gew.-% Lösungsmittelgemisch, 1,5 Gew.-% Dispergiermittel (®Genamin CO 20), 3,5 Gew.-% Binder (®Acryloid) und 1 Gew.-% Weichmacher (®Palatinol C). Die Gießmasse weist eine Viskosität von 500 MPas auf, gemessen mit einem Rotationsviskosimeter. Die Gießmasse wird mit einem 0,2 mm Gießschuh und einer Gießgeschwindigkeit von 24 cm/h auf ein 100 µm dickes Substrat aus Silber vergossen und führt nach dem Verdampfen des Lösungsmittels bei Raumtemperatur zu rißfreien, blasenfreien Grünfolien mit einer gleichmäßigen Dicke von 103 bis 108 µm. Die verbleibenden organischen Additive werden 10 Stunden bei 500°C ausgeheizt und die Grünfolie bei 845°C unter einem Gasgemisch Ar:O₂ von 10:1 zur Bi-3-Schichtphase umgesetzt.

### Beispiel 2

Ein über Oxalatfällung hergestelltes Pulver der Zusammensetzung Bi_{2.18}Sr₂CaCu₂O₈₊ₓ wird zu einem Schlicker mit dem Lösungsmittelgemisch Toluol/Ethanol 30/70 mit der Viskosität 300 MPas verarbeitet. Das Pulver weist im Grünzustand eine spezifische Oberfläche von 28 m²/g auf und zeigt nach 10 h Vorkalzinierung bei 450°C einen d₅₀-Wert von 1,9 µm. Die chemische Stoffzusammensetzung des Schlickers ist analog Beispiel 1, die mengenmäßigen Anteile entsprechen den optimierten Werten in Tabelle 1. Das Vergießen mit einem 0,1 mm Gießschuh und einer Gießgeschwindigkeit von 24 cm/h auf ein 100 µm dickes Substrat aus Silber führt nach dem Verdampfen der Lösungsmittel wie in Beispiel 1 zu rißfreien, blasenfreien Grünfolien mit einer gleichmäßigen Dicke von 54 - 57 µm. Nach dem Ausheizen der Organik 10 h/500°C wird die Folie 20 Stunden auf 870°C erhitzt und dem Ofen entnommen.

Röntgenographisch besteht die Probe zu über 90 % aus texturiertem Material mit der Bi₂Sr₂CaCu₂O₈₊ₓ-Struktur und zeigt eine Sprungtemperatur von 82 K.

## Patentansprüche

1. Gießmasse für keramische Grünfolien aus hochtemperatursupraleitendem Precursormaterial, dadurch gekennzeichnet, daß die Gießmasse als keramisches Ausgangsmaterial für den Foliengießprozeß ein Precursorpulver aus den Elementen Bi, Sr, Ca, Cu und O enthält, das durch modifizierte Copräzipitation hergestellt wird, eine mittlere Korngröße von < 5 µm besitzt und eine spezifische Oberfläche von > 25 m²/g aufweist.

2. Gießmasse nach Anspruch 1, dadurch gekennzeichnet, daß die Zusammensetzung des Precursorpulvers den supraleitenden Phasen Bi₂Sr₂CaCu₂O₈₊ₓ, Bi₄Sr₄Ca₁Cu₃O₁₄₊ₓ oder Bi₂Sr₂Ca₂Cu₃O₁₀₊ₓ, beziehungsweise Ansätzen, die zu weitgehend phasenreinen Proben führen, entspricht, wobei Bi partiell durch Pb ersetzt sein kann.

3. Gießmasse nach Anspruch 1 oder 2, dadurch gekennzeichnet, daß sie als Lösungsmittel für die keramische Matrix ein Gemisch aus 20 bis 40 Gew.-% Toluol und 60 bis 80 Gew.-% Ethanol enthält.

4. Gießmasse nach einem der Ansprüche 1 bis 3, dadurch gekennzeichnet, daß sie als Dispergiermittel ein tertiäres Alkoxyalkylamin enthält, das eine Alkylgruppe mit 10 bis 21 C-Atomen besitzt.

5. Gießmasse nach einem der Ansprüche 1 bis 4, dadurch gekennzeichnet, daß sie als Binder einen langkettigen organischen Ester mit wenigstens 17 C-Atomen enthält.

6. Gießmasse nach einem der Ansprüche 1 bis 5, dadurch gekennzeichent, daß sie eine Menge von 50 bis 60 Gew.-% an keramischem Material, von 30 bis 45 Gew.-% an Lösungsmittel, von 0,2 bis 4 Gew.-% an Dispergiermittel und von 1 bis 6 Gew.-% an Binder enthält, bezogen jeweils auf das Gesamtgewicht der Gießmasse.

7. Verfahren zum Herstellen einer Gießmasse nach einem der Ansprüche 1 bis 6, bei dem das zum Precursor zersetzte Oxalatpulver in ein Lösungsmittelgemisch eingegeben und zusammen mit Dispergiermittel über eine Zeitdauer von wenigstens zwei Stunden homogenisiert, anschließend mit Ultraschall behandelt, danach mit Binder sowie gegebenenfalls Weichmacher versetzt, wieder homogenisiert und schließlich im Vakuum entgast wird.

8. Verfahren nach Anspruch 7, dadurch gekennzeichnet, daß die Viskosität der Gießmasse im Bereich von 100 bis 600 MPas eingestellt wird.

9. Verfahren zum Herstellen eines gegossenen Bauteils aus einer Gießmasse nach einem der Ansprüche 1 bis 6, hergestellt nach Anspruch 7 oder 8, bei dem die Gießmasse mit einem Gießschuh in einer Halteapparatur auf ein Endlosband mit automatischem Vortrieb vergossen und dann das Lösungsmittel bei Temperaturen im Bereich von 20 bis 120 °C ausgetrieben wird.

10. Verfahren zum Herstellen eines hochtemperatursupraleitenden Bauteils aus einem gegossenen Bauteil nach Anspruch 9, bei dem die verbleibenden organischen Anteile bei Temperaturen zwischen 200 und 500°C ausgeheizt werden und bei dem der nach dem Ausheizen der organischen Bestandteile resultierende Precursorformkörper bei Temperaturen zwischen 750 und 900°C zum fertigen hochtemperatursupraleitenden Bauteil umgesetzt wird.
